(19) Europäisches Patentamt
European Patent Office
Office européen des brevets

(11) Veröffentlichungsnummer: **0 503 282 A1**

(12) # EUROPÄISCHE PATENTANMELDUNG

(21) Anmeldenummer: **92102175.4**

(22) Anmeldetag: **10.02.92**

(51) Int. Cl.5: **H03M 3/02**, H03H 17/02, H04B 1/16, H03H 17/04, H03H 17/06

(30) Priorität: **05.03.91 DE 4106928**

(43) Veröffentlichungstag der Anmeldung: **16.09.92 Patentblatt 92/38**

(84) Benannte Vertragsstaaten: **AT DE ES FR GB IT SE**

(71) Anmelder: **Blaupunkt-Werke GmbH**
**Robert-Bosch-Strasse 200**
**W-3200 Hildesheim(DE)**

(72) Erfinder: **Nyenhuis, Detlev**
**Berliner Strasse 30**
**W-3226 Sibbesse(DE)**
Erfinder: **Vogt, Lothar, Dr.**
**Am Sonnenhang 11c**
**W-3156 Hohenhameln(DE)**
Erfinder: **Kässer, Jürgen, Dr.**
**Ahornweg 5**
**W-3201 Diekholzen(DE)**

(74) Vertreter: **Eilers, Norbert, Dipl.-Phys.**
**Blaupunkt-Werke GmbH**
**Robert-Bosch-Strasse 200**
**W-3200 Hildesheim(DE)**

(54) **Autoradio.**

(57) Es wird ein neues Autoradio beschrieben mit einem verbesserten Signal-Rauschabstand an den Grenzen dem Zwischenfrequenzen-Frequenzbandes durch eine Analog Digital Wandlung des Zwischenfrequenzsignals mittels eines speziellen Filters.

Fig. 1

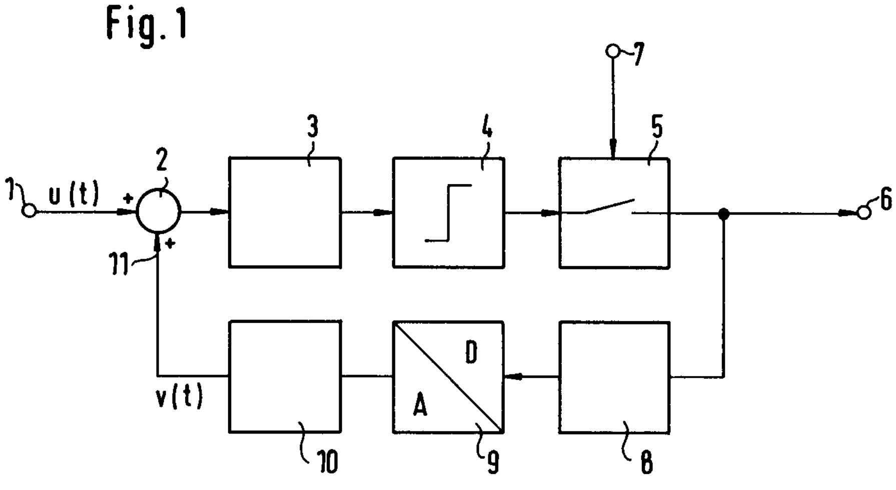


EP 0 503 282 A1

Das Schutzrecht betrifft ein neues Autoradio oder andere entsprechende Empfänger mit einer Zwischenfrequenzstufe für eine schmalbandig frequenzmodulierte Trägerfrequenz.

Autoradios wie auch andere mobile Funkempfänger werden oft unter schlechten Empfangsbedingungen betrieben. Neben einer wechselnden Feldstärke - die insbesondere unter Brücken und in Tunneln extrem geringe Werte annehmen kann - und neben dem Mehrwege-Empfang beeinträchtigen oft elektromagnetische Störfelder die Empfangsqualität. Zur Verarbeitung von gestörten Signalen werden in zunehmendem Maße digitale Schaltungen verwendet, wobei eine möglichst frühzeitige Analog/Digital-Wandlung der empfangenen Signale erwünscht ist, was wiederum Analog/Digital-Wandler für hohe Frequenzen erfordert. Solche hochfrequenten Analog/Digital-Wandler erfordern einen hohen Aufwand, wenn eine hohe Empfangsgüte gewährleistet sein soll.

Zur Umwandlung eines analogen Signals in ein digitales Signal werdem Signal zu äquidistanten Zeitpunkten mit Hilfe eines Abtast-Halte-Gliedes Abtastwerte entnommen. Diese Abtastwerte werden anschließend in Zahlenwerte umgewandelt. Damit die entstehende Zahlenfolge ein kontinuierliches Signal ohne Informationsverlust darstellt, ist die Erfüllung des Abtasttheorems erforderlich, nach welchem die Abtastfrequenz mindestens doppelt so groß sein muß wie die höchste im Signal vorkommende Frequenz. Je höher diese Frequenz ist, desto kürzer ist diejenige Zeit, innerhalb der aus einem Abtastwert ein entsprechender Zahlenwert abgeleitet werden kann.

Diese Forderung ist um so schwerer zu erfüllen, je höher die geforderte Genauigkeit der Analog/Digital-Wandlung ist. Daraus ergibt sich für Analog/Digital-Wandler für hohe Frequenzen ein hoher technischer Aufwand, der insbesondere für Autoradios nicht tragbar ist. Außerdem ergibt sich bei der bekannten Analog/Digital-Wandlung eine Unsicherheit des Abtast-Zeitpunktes (Jitter), der zu Ungenauigkeiten des Ergebnisses führt.

Aus der US PS 48 76 542 sind sogenannte Sigma-Delta-Wandler für die Umsetzung eines Audio-Signals in einen 1-Bit-Datenstrom bekannt geworden. Der logische Pegel des 1-Bit-Datenstroms ist davon abhängig, ob das zu wandelnde Signal größer oder kleiner als ein aufgrund dieses Vergleichs gewonnenes und anschließend integriertes Signal ist. Diese Wandler sind in ihrem Aufbau sehr einfach, benötigen jedoch eine im Vergleich zur höchsten Signalfrequenz sehr hohe Abtastrate, die wesentlich oberhalb der Grenze liegt, die das erwähnte Theorem fordert.

In der älteren Patentanmeldung P 41 04 882 (R 2119) ist vorgeschlagen worden, zur Analog/Digital-Wandlung eines Zwischenfrequenzsignals einen solchen Sigma-Delta-Wandler mit einer Taktfrequenz zu betreiben, die nicht selbst, sondern von der ein ganzzahliges Vielfaches in der Nähe der Zwischenfrequenz liegt, und zwar derart, daß zwischen diesem ganzzahligen Vielfachen und einem der beiden benachbarten halbzahligen Vielfachen das Frequenzband der Modulation des Zwischenfrequenzsignals liegt.

Bei der weiteren Untersuchung dieses Lösungsweges zeigte sich, daß bei einem derart aufgebauten Analog/Digital-Wandler für das zwischenfrequente Signal an den Grenzen des von diesem Modulationssignal eingenommenen Frequenzbandes der Signal-Rauschabstand noch zu gering bleibt, um die bekannten Qualitätsanforderungen bei solchen Empfängern erfüllen zu können.

Die Erfindung löst die Aufgabe einer Verbesserung des Signal-Rauschabstandes an den Grenzen des zwischenfrequenten Frequenzbandes durch die im Anspruch 1 genannten Merkmale.

Anhand der Zeichnung wird die Erfindung näher erläutert.

| | |
|---|---|
| Figur 1 | zeigt das Blockschaltbild des erfindungsgemäßen Wandlers, |
| Figur 2 | zeigt die Signal-Rauschkurve in einem erfindungsgemäßen Wandler, |
| Figur 3 | zeigt einen entsprechenden Kurvenverlauf in einem Sigma-Delta-Wandler, |
| Figur 4 und 5 | Signal-Rauschkurven weiterer Ausführungsbeispiele der Erfindung. |

Das Blockschaltbild in Figur 1 ähnelt dem des bekannten Sigma-Delta-Wandlers.

Dem analogen Eingangssignal u(t) an der Eingangsklemme 1, nämlich der im nicht näher dargestellten Autoradio in bekannter Weise gewonnenen modulierten Zwischenfrequenz mit einer Frequenzlage von 10,7 MHz, wird in einer Addierstufe 2 ein Zweites Signal v(t) hinzugefügt, d. h. die momentanen Amplituden beider Signale werden überlagert. Auf die Gewinnung des zweiten Signals v(t) wird später näher eingegangen.

Das Ausgangssignal der Addierstufe 2 wird einem IIR-Filter 3 mit der Übertragungscharakteristik

$$\frac{1}{a_0 + a_1 z^{-1} + a_2 z^{-2}}$$

zugeführt. An das IIR-Filter 3 schließt sich eine Schwellwertstufe 4 an, deren Ausgangssignal positiv (+1) ist, wenn das IIR-gefilterte Signal einen Schwellwert überschreitet, dagegen null oder negativ (-1) ist, wenn das IIR-gefilterte Signal den Schwellwert nicht erreicht. Der Zustand des Signals

am Ausgang der Schwellwertstufe 4 wird mit dem getakteten Schalter 5 in gleichen Zeitabständen abgefragt und an den Ausgang des Wandlers 6 weitergeleitet.

Das Taktsignal am Steuereingang 7 des Schalters 5 kann entsprechend der Lehre des älteren Patents P 41 04 882 gewählt sein, d. h. ein ganzzahliges Vielfaches der Taktfrequenz liegt in der Nähe des zwischenfrequenten Trägers, und zwischen diesem Vielfachen und einem der beiden benachbarten halbzahligen Vielfachen liegt das Frequenzband der Modulation des zwischenfrequenten Trägers, es kann jedoch auch in bekannter Weise oberhalb des Zwischenfrequenzträgers liegen.

Das am Ausgang 6 anstehende digitale Ausgangssignal des Wandlers wird in einem Rückkopplungszweig in einem Verzögerungsglied 8 um eine Takteinheit verzögert und dann über einen Digital/Analog-Wandler 9 in ein analoges Signal zurückgewandelt. Hier entsteht ein Signal $u_{(t-\tau)}$, das anschließend in einem FIR-Filter 10 mit der Übertragungscharakteristik $a_1 + a_2 \cdot z^{-1}$ gefiltert wird. Dieses Signal ist dann das bereits erwähnte Signal v(t) am zweiten Eingang 11 der Addierstufe 2.

Die übereinstimmenden Konstanten in den beiden Charakteristiken der Filter sind frei wählbar. Mit ihnen läßt sich die Lage des Minimums der Signal-Rauschkurve festlegen. Eine solche Kurve ist in der Figur 2 wiedergegeben. Hier ist

$a_0 = 1$
$a_1 = -1{,}98$
$a_2 = 1$

wobei an den Eingang der Schaltung nach Figur 1 ein frequenzmodulierter Träger mit einer Frequenz von 10,7 MHz angelegt ist und die Abtastrate am Schalter 5 mit 10,5 MHz gewählt ist.

Die Kurve gibt dabei am Ausgang 6 des Wandlers gemessene Signal im Verhältnis zu dem Eingangssignal (in dB aufgetragen) an.

In Figur 3 ist zum Vergleich die Signal-Rauschkurve am Ausgang eines Sigma-Delta-Wandlers wiedergegeben, der entsprechend mit 10,5 MHz abgetastet ist.

Aus dem Kurvenvergleich ergibt sich, daß das Minimum der Signal-Rauschkurve durch die erfindungsgemäße Maßnahme nach rechts verlagert worden ist und eine größere Breite aufweist. Die Größe der Verlagerung - und damit der Gewinn an Bandbreite mit einem guten Signal-Störabstand - ist durch die Wahl der Konstanten beeinflußbar.

Ein guter Signal-Rauschabstand ist in einem Autoradio besonders erwünscht und sollte sich über die ganze Modulations-Bandbreite des Trägers erstrecken. Wie sich sehen läßt, ist mit der Erfindung ein Schritt in die richtige Richtung getan.

Figur 4 zeigt die Signal-Rauschkurve für einen Wandler, für den die Werte gelten

$a_0 = 1$
$a_1 = -1{,}95$
$a_2 = 1$

und in dem die Abtastraste 5,25 MHz beträgt, während an dem Eingang wiederum ein 10,7-MHz-Träger liegt.

Figur 5 zeigt eine Signal-Rauschkurve für einen Wandler, der mit einer gegenüber der Trägerfrequenz - von hier 25 kHz - mit einer hohen Abtastrate von 10,5 MHz abgetastet wird, für den die Werte gelten

$a_0 = 1$
$a_1 = -2$
$a_2 = 1$

Diese Kurve entspricht in ihrer Qualität einer zweistufigen Sigma-Delta-Wandler-Kaskade. Auch dieser Kurvenverlauf zeigt, daß sich durch die erfindungsgemäßen Maßnahmen die Breite des Frequenzbandes mit einem guten Signal-Rauschabstand merklich erhöhen läßt.

Wie der Integrator in dem Sigma-Delta-Wandler lassen sich auch die anderen Konfigurationen der Filter wahlweise als Rechenprogramm oder als Hardware-Lösungen darstellen.

Das Prinzip der IIR-Filter und der FIR-Filter ist dem Fachmann unter anderem aus der Veröffentlichung des Springer-Verlages: H. W. Schüßler, "Digitale Signalverarbeitung", Band 1, Analyse diskreter Signale und Systeme, 2. Auflage, Kapitel 4.6, bekannt.

**Patentansprüche**

**1.** Autoradio oder dergleichen Empfänger, in denen die empfangene mit einem relativ schmalbandigen Nutzsignal modulierte Trägerfrequenz in eine mit dem Nutzsignal modulierte Zwischenfrequenz umgesetzt ist und mit einer Schaltungsanordnung zur Analog/Digital-Wandlung des Zwischenfrequenzsignals, mit einer Addierstufe, einer Begrenzerstufe und einem mit einer vorgegebenen Taktfrequenz getakteten Schalter und mit einer Rückkopplungsschleife, die einen Digital/Analog-Wandler umfaßt,
gekennzeichnet
durch ein zwischen der Addierstufe (2) und der Begrenzerstufe (4) eingefügtes IIR-Filter (3) mit einer Übertragungscharakteristik

$$\frac{1}{a_0 + a_1 z^{-1} + a_2 z^{-2}}$$

und durch ein dem A/D-Wandler (8) im Rückkopplungskreis nachgeschaltetes FIR-Filter (9) mit der Übertragungscharakteristik

$a_1 + a_2 . z^{-1}$

**2.** Autoradio nach Anspruch 1,
dadurch gekennzeichnet,
daß ein ganzzahliges Vielfaches der Taktfrequenz in der Nähe der Zwischenfrequenz liegt und zwischen diesem Vielfachen und einem der beiden benachbarten halbzahligen Vielfachen das Frequenzband der Modulation des zwischenfrequenten Trägers liegt.

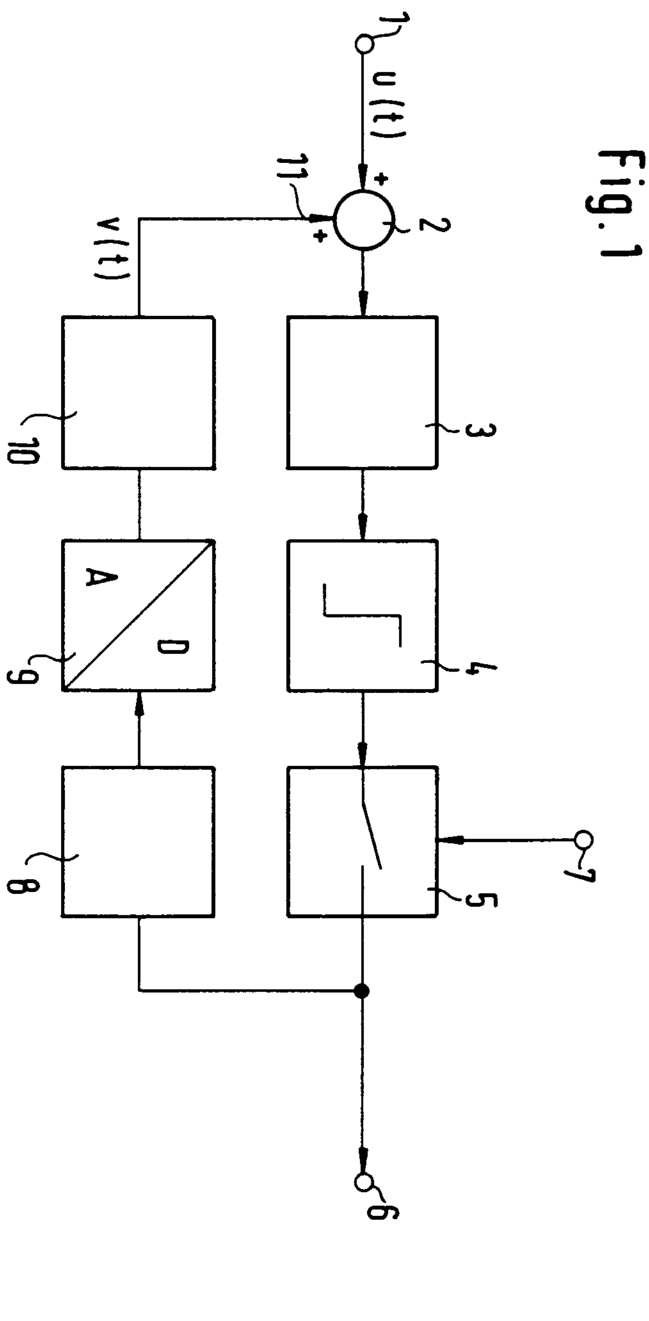


Fig. 1

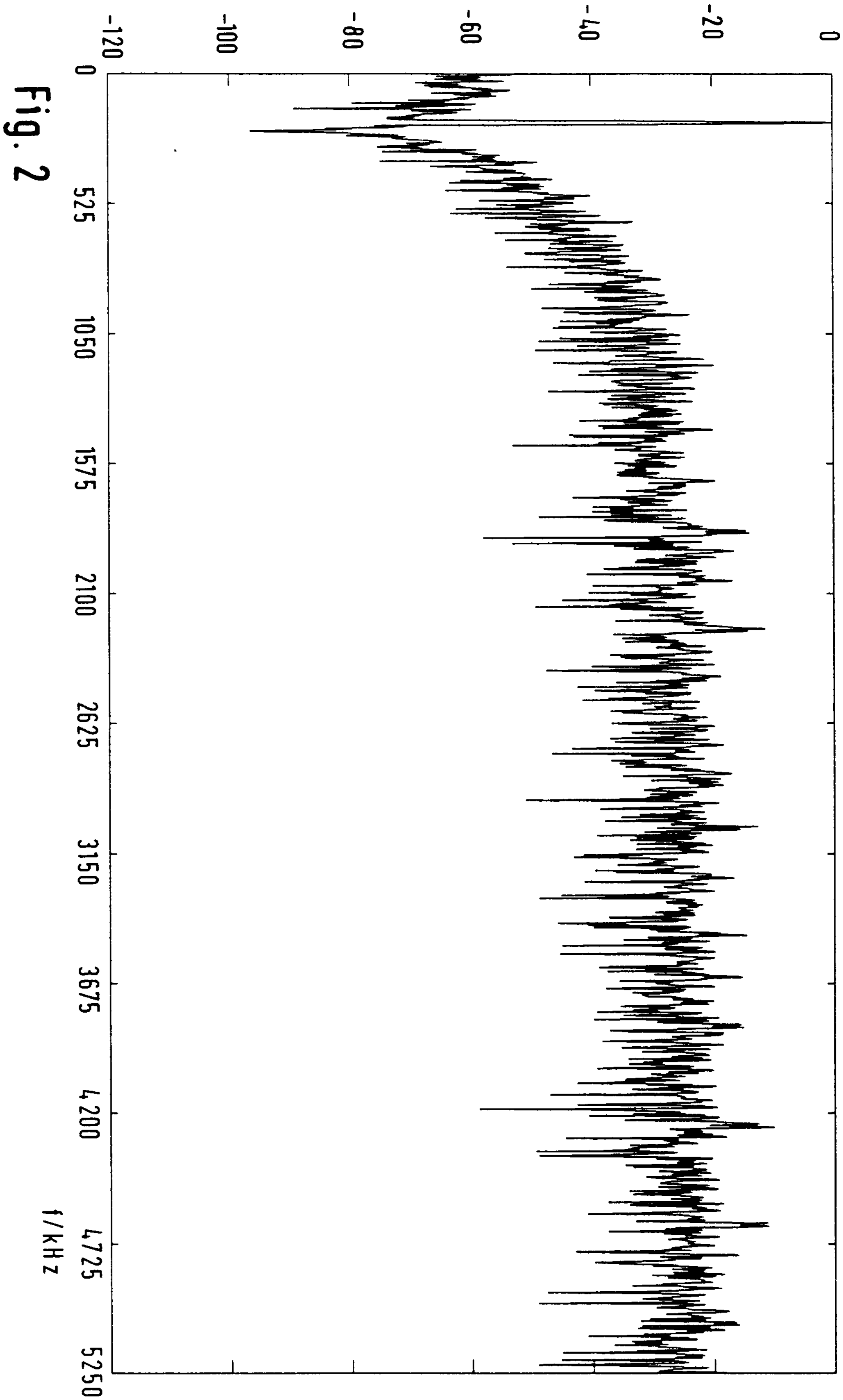
0
-20
-40
-60
-80
-100
-120
0
525
1050
1575
2100
2625
3150
3675
4200
4725
5250
f/kHz

Fig. 2

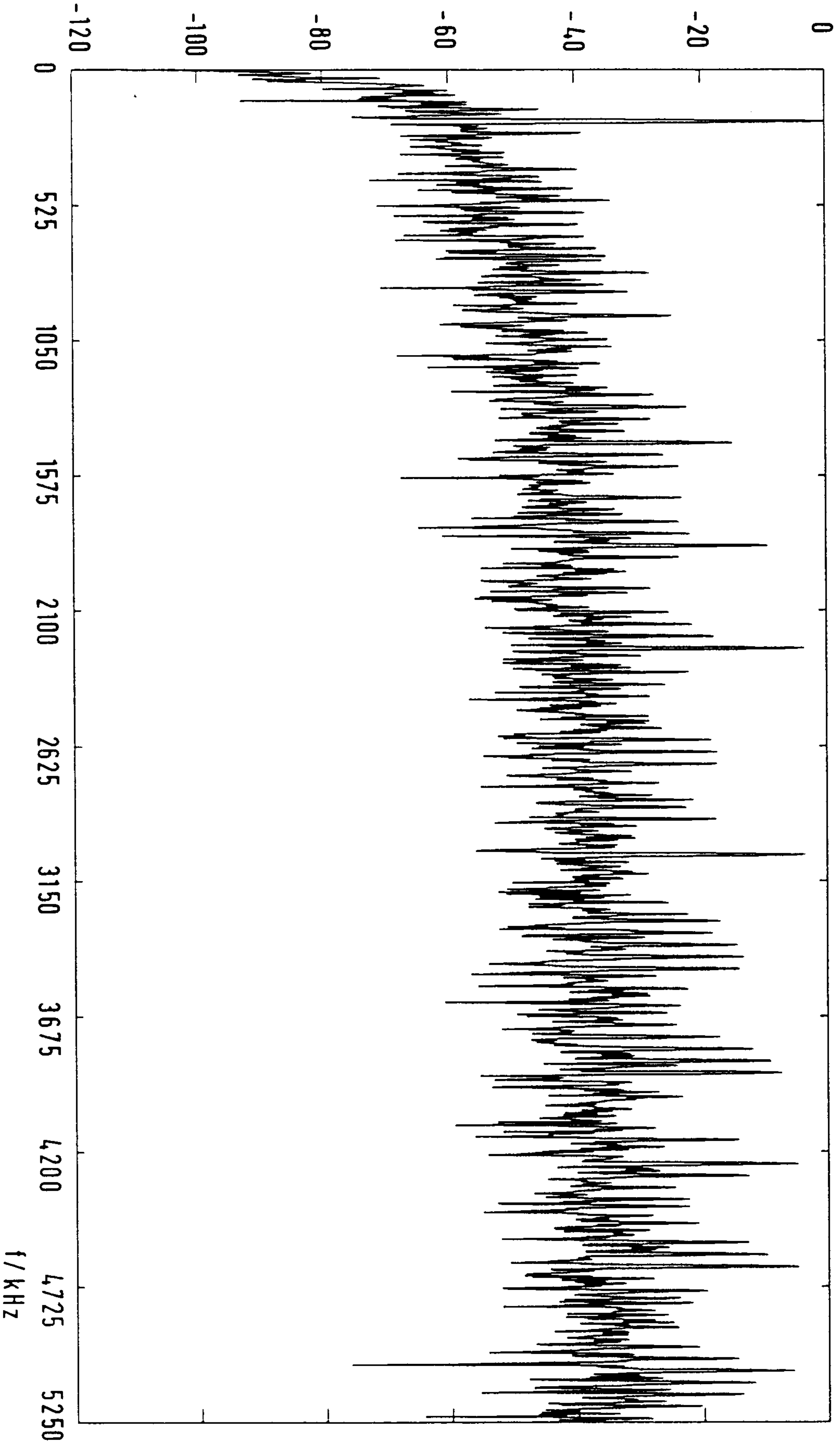
0
-20
-40
-60
-80
-100
-120
0
525
1050
1575
2100
2625
3150
3675
4200
4725
5250
f / kHz

Fig. 3

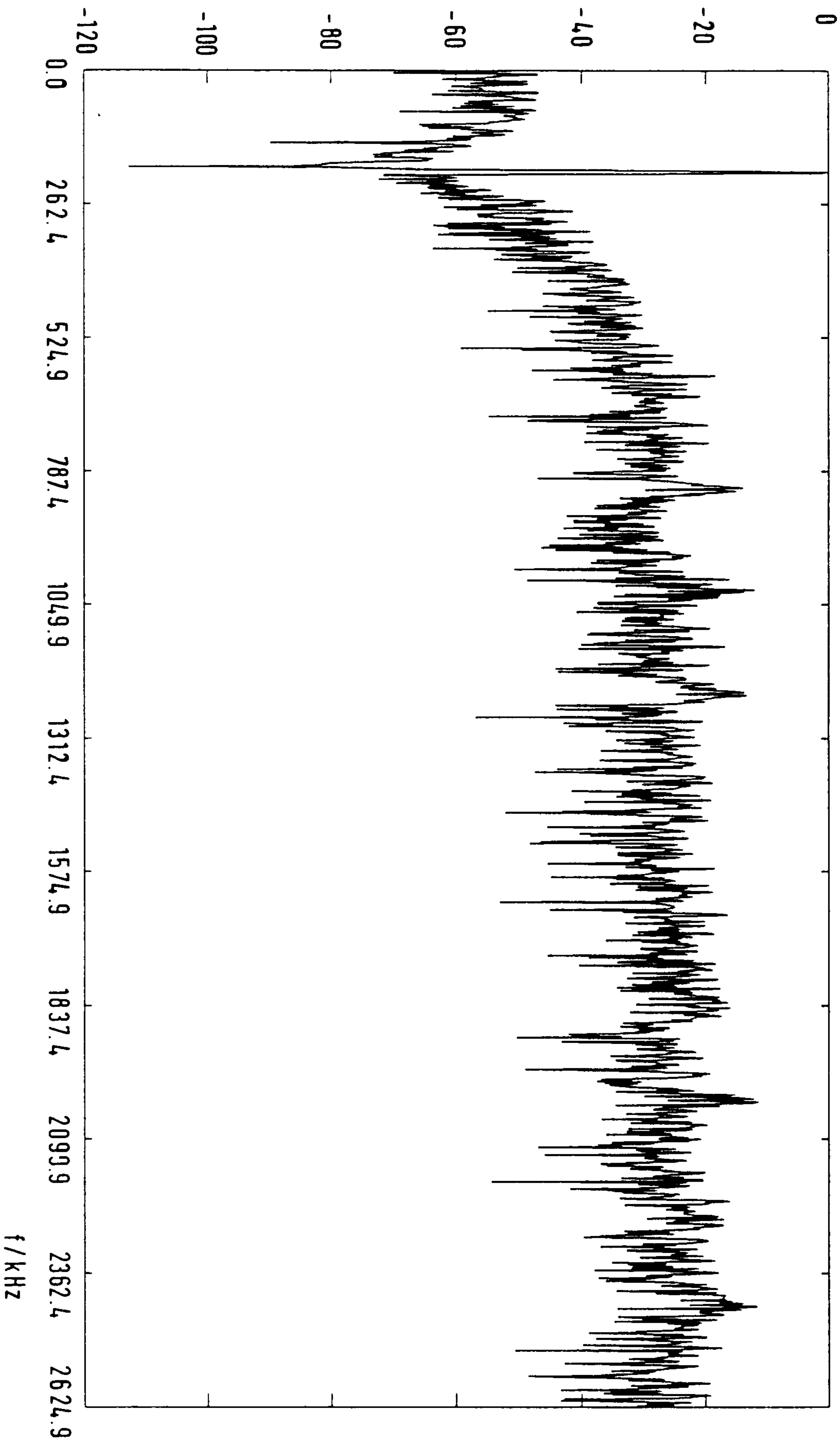
0
-20
-40
-60
-80
-100
-120
0.0
262.4
524.9
787.4
1049.9
1312.4
1574.9
1837.4
2099.9
2362.4
2624.9
f/kHz

Fig. 4

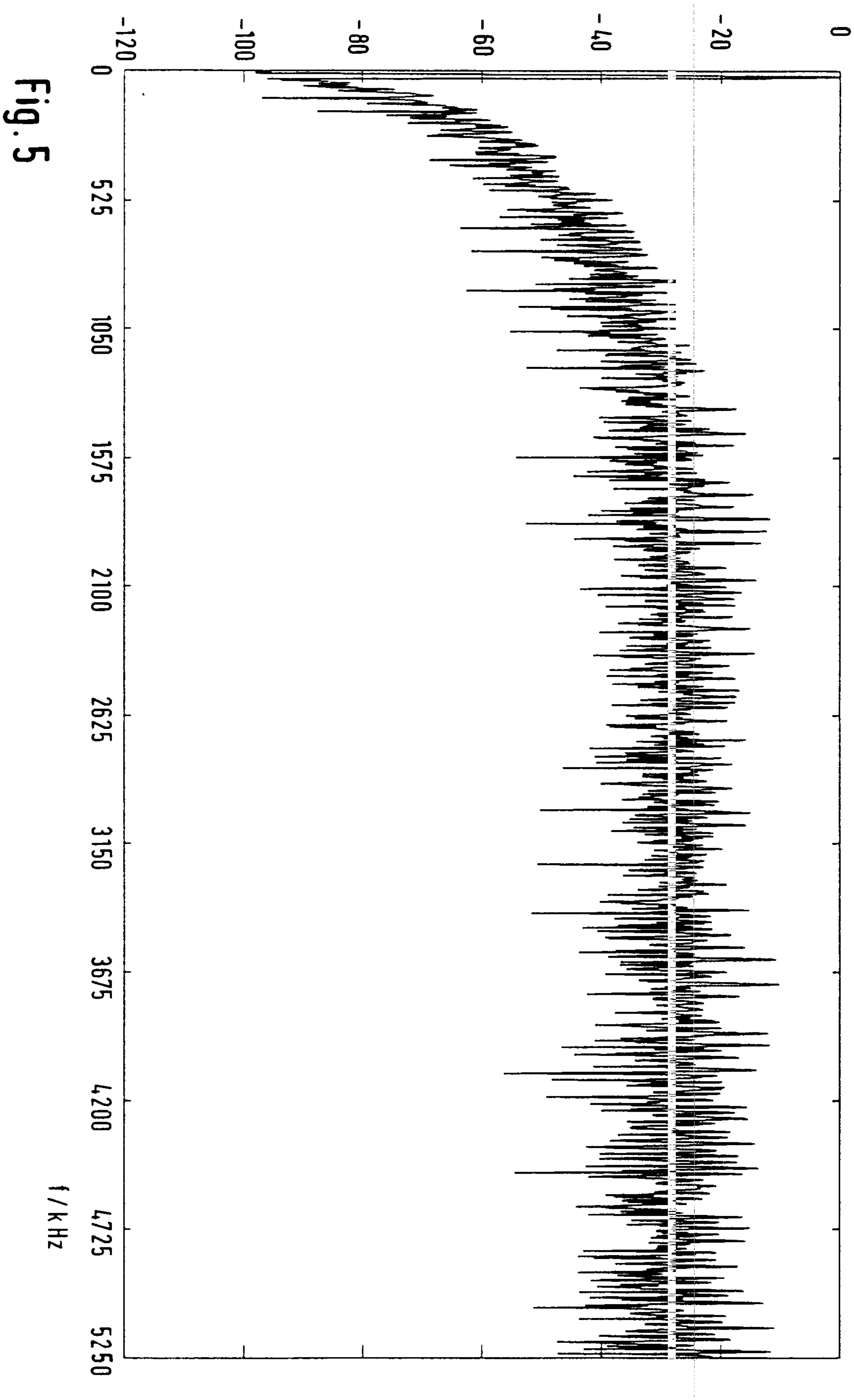
0
-20
-40
-60
-80
-100
-120
0
525
1050
1575
2100
2625
3150
3675
4200
4725
5250
f / kHz

Fig. 5

Europäisches Patentamt

# EUROPÄISCHER RECHERCHENBERICHT

Nummer der Anmeldung

EP 92 10 2175

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | SIGNAL PROCESSING. Bd. 22, Nr. 2, Februar 1991, AMSTERDAM NL Seiten 139 - 151; DRESSLER: 'Interpolative bandpass A/D-conversion' * Seite 142, linke Spalte, Zeile 1 - Seite 143, linke Spalte, Zeile 20; Abbildungen 1,5 * --- | 1 | H03M3/02<br>H03H17/02<br>H04B1/16<br>H03H17/04<br>H03H17/06 |
| A | INTERNATIONAL SYMPOSIUM ON CIRCUITS AND SYSTEMS Bd. 1, 7. Juni 1985, KYOTO, JAPAN Seiten 283 - 286; KIMURA ET AL: 'balanced approximation of digital FIR filter with linear phase charactoristics' * Seite 283, linke Spalte, Zeile 20 - rechte Spalte, Zeile 8 * ----- | 1 | |
| | | | RECHERCHIERTE SACHGEBIETE (Int. Cl.5) |
| | | | H03M<br>H03H<br>H04B |

Der vorliegende Recherchenbericht wurde für alle Patentansprüche erstellt

| Recherchenort | Abschlußdatum der Recherche | Prüfer |
|---|---|---|
| DEN HAAG | 03 JULI 1992 | WRIGHT J.P. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)